# EUROPEAN PATENT APPLICATION

(11) **EP 0 929 096 A2**
(43) Date of publication of application: **14.07.1999**
(21) Application number: 98310216.1
(22) Date of filing: 14.12.1998
(51) Int. Cl.: H01L 21/3205, H01L 21/321

(54) **Metal patterning by formation of etchable plural metal compositions**

(30) Priority: 08.01.1998 US 4689
(71) Applicant: International Business Machines Corporation, Armonk, N.Y. 10504 (US)
(72) Inventor: Bronner, Gary B., Stormville, New York 12582 (US); Gambino, Jeffrey P., Gaylordsville, Connecticut 06755 (US); Kotecki, David E., Hopewell Junction, New York 12533 (US)
(74) Representative: Burt, Roger James, Dr.

(57) **Abstract**

Patterned difficult-to-etch metal structures are formed by converting a difficult-to-etch metal to an etchable plural metal composition in regions where the difficult-to-etch metal is to be removed.

## Description

The present invention is concerned with forming a patterned metal structure and especially with forming a patterned metal electrode wherein the metal itself is difficult to etch. The present invention is particularly advantageous for fabricating electrodes used in microelectronic applications such as dynamic random access memories.

Memory cells in microelectronics often include a ferroelectric capacitor as the memory element. The ferroelectric capacitor as the memory element in a semiconductor nonvolatile memory must retain data for an extended period of time at a given storage temperature. The typical ferroelectric capacitors comprise two electrodes separated by a dielectric. The dielectric employed should be a material that is "ferroelectric" in that it can contain a reversible electric polarization in the absence of an applied electric field. Some typical dielectric materials include lead zirconate titanate, barium titanate, phase III potassium nitrate, barium strontium titanate and strontium bismuth tantalate.

Platinum and iridium have been used as electrode material for ferroelectric materials because of their oxidation resistance or conductive oxide formation, high temperature stability, and high barrier height. However, difficulties exist in using them in microelectronic applications such as dynamic random access memories (DRAMs) because these metals, as well as other noble metals, are relatively difficult to pattern by conventional processes such as reactive ion etching due to the lack of formation of volatile etch products. The dry etching of these materials occurs mostly through a sputter etch, rather than a chemical etch mechanism, making it difficult to control sidewall angle and critical dimensions of small features.

Thus, there is a need for improved methods of patterning difficult-to-etch metals.

Accordingly, the present invention provides improved fabrication techniques for patterning difficult-to-etch metals. In addition, the invention provides processes for patterning difficult-to-etch metals which enable conventional etching techniques to be employed effectively, especially for producing small features.

According to the invention, those regions of the difficult-to-etch metal which are to be removed in the patterning of the difficult-to-etch metal are converted to an etchable plural metal composition. The etchable plural metal composition may be an intermetallic compound(s), an alloy(s) or combination thereof.

More particularly, the method of the invention for forming a patterned metal structure comprises providing a patterned layer of a sacrificial metal composition on a surface wherein the sacrificial metal composition is capable of reacting with the difficult-to-etch metal to provide a plural metal composition capable of being etched, and providing a layer of difficult-to-etch metal over the patterned sacrificial metal composition layer, the layer of difficult-to-etch metal contacting the surface in areas corresponding to spaces in the patterned the sacrificial metal composition. The pattern of the patterned sacrificial metal composition layer is located to correspond to regions where it is desired to remove deposited difficult-to-etch metal. The portions of the deposited difficult- to-etch metal directly overlying the pattern of the sacrificial metal composition are preferably in physical contact with the underlying sacrificial metal composition. Next, an etchable plural metal composition is formed of the difficult-to-etch metal with at least a portion of the sacrificial metal composition, and then the etchable plural metal composition is removed leaving behind the layer of the difficult-to-etch metal in those regions where such metal is desired.

The invention is especially useful for forming patterns of noble metals, more especially in making electrodes for use in ferroelectric capacitors.

Preferred embodiments of the present invention will now be described by way of example with reference to the accompanying drawings, in which:

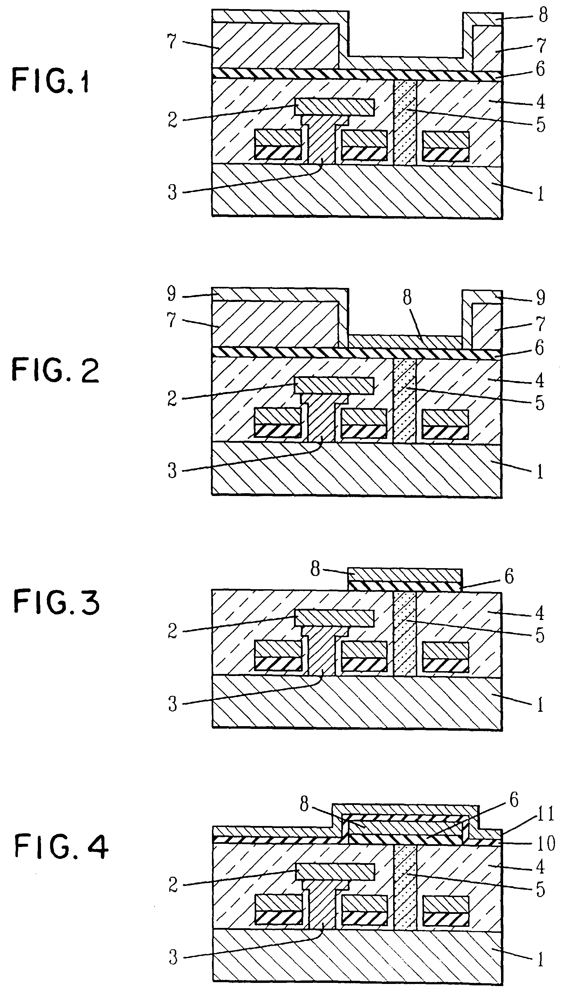

Figs. 1-4 are schematic diagrams of semiconductor structures in various stages of fabrication according to the process of the present invention. The figures are not drawn to scale.

As illustrated in Fig. 1, a typical underlying semiconductor structure may contain word lines 1, bit lines 2, bit line contacts 3, planarized interlevel dielectric 4 such as silicon dioxide and capacitor contact 5 such as polysilicon and a diffusion barrier 6 (typically about 20 to about 100 nanometers thick) such as TaSiN.

According to a method of the invention, a relatively thick patterning layer 7 of sacrificial metal composition is deposited on the diffusion barrier layer 6. The patterning layer 7 is preferably about 100 to about 2000 nanometers thick, more preferably about 500 to about 1000 nanometers thick. The thickness of the patterning layer is preferably sufficient to adequately convert the overlying difficult-to-etch metal to an etchable plural metal composition. The patterning layer can be deposited by sputtering or by evaporation.

The sacrificial metal composition of the patterning layer is itself preferably easy to pattern with the desired precision. The patterning layer 7 must be capable of being alloyed or reacted with the difficult-to-etch metal to provide an etchable plural metal composition. The etchable plural metal composition may be an alloy or intermetallic compound or combinations of such phases. Typically, the etchable plural metal composition will have a relatively low content of the difficult-to-etch metal. Examples of suitable sacrificial metal compositions are metals selected from the group consisting of aluminium, titanium, germanium, tin and mixtures or alloys thereof. Aluminium is a generally preferred sacrificial metal composition.

The patterning layer 7 sacrificial metal composition is then delineated or patterned using any suitable known lithographic technique. For instance, aluminium can be patterned applying and patterning a photoresist layer or other mask layer over patterning layer 7 using known photolithography techniques followed by reactive ion etching of the sacrificial metal composition using an etch that stops on the underlying diffusion barrier layer 6 whereby the sacrificial metal composition is removed in those regions where the difficult-to-etch metal is to remain.

Next, the difficult-to-etch metal 8 is deposited over the patterned layer 7 and barrier layer 6, preferably by well known techniques such as sputtering or evaporation. If desired, the difficult-to-etch metal can be deposited by a directional deposition technique such as collimated sputtering in order to minimize its coverage on the vertical surfaces (i.e. to minimize step coverage) of patterned layer 7. Preferably, the difficult-to-etch metal layer is about 5 to about 500 nanometers thick, and more preferably about 50 to about 300 nanometers thick. The difficult-to-etch metals are typically characterized by their inability or difficulty in forming volatile halides under conventional etching conditions involving halogen-containing etchants. Preferred difficult-to-etch metals include the noble metals such as platinum, iridium, gold and palladium, with platinum and iridium being more preferred and platinum being most preferred. Mixtures and alloys of these difficult-to-etch metals can be used, if desired.

An etchable plural metal composition 9 is then formed from the difficult-to- etch metal 8 and patterned sacrificial metal composition 7 as illustrated in Fig. 2. The formation of the etchable plural metal composition 9 is preferably facilitated by heating the structure. In the case of aluminium, the structure is preferably annealed at a temperature of about 250°C to about 500°C for about 1 to about 30 minutes in order to form an etchable plural metal composition such as Al₄Pt in the case where platinum is the difficult-to-etch metal. The annealing conditions are preferably selected in order to fully react the difficult-to-etch metal directly overlying the patterned alloying material 7 with minimal lateral reaction into areas 8 where the difficult-to-etch metal is desired. Processes for forming etchable plural metal compositions with other combinations of sacrificial metal compositions and difficult-to-etch metals can be carried out using similar techniques. Examples of etchable plural metal compositions of iridium are Ir₂Al₉ and IrTi₃. Examples of etchable plural metal compositions of gold are AuAl₂, AuTi₃ and AuSn₄. Examples of etchable plural metal compositions of palladium are PdAl₄, PdGe, PdSn₄ and PdTi₄. While the above examples are specified as stoichiometric compounds, it should be understood that the invention also covers methods where etchable plural metal compositions containing non-stoichiometric compounds or alloys are formed.

Next, the etchable plural metal composition 9 is selectively removed by a process that removes the etchable plural metal composition material with high selectivity relative to the difficult-to-etch metal. In particular, etching or chemical-mechanical polishing can be employed to perform the selective removal Where aluminium is used as the sacrificial metal composition and platinum as the difficult-to-etch metal, the preferred removal process is a wet etch in an HCl-based solution. When the sacrificial metal composition is titanium, the preferred etch is a hydrogen peroxide (H₂O₂)-based wet etch. In addition, a hydrogen peroxide-based wet etch is also preferred for etchable plural metal compositions containing germanium such as Ge₂Pt. The preferred etch for sacrificial metal compositions of tin, such as Sn₄Pt, is a HCl-based wet etch. The etching is preferably carried out at temperatures of about 20 to 80°C, more preferably about 40 to 60°C, typically about 50°C. The etching is preferably conducted for about 10 seconds to about 2 hours, a specific example being about 5 minutes.

If little step coverage of the difficult-to-etch metal occurs on the vertical side walls of the patterning material and a portion of pure sacrificial metal composition remains under the formed etchable plural metal composition, the etch process can be enhanced by "lifting off" the etchable plural metal composition (and any overlying unreacted difficult-to-etch metal) since etchable plural metal composition typically etches more slowly than any pure sacrificial metal composition used to form the patterning layer.

If desired, the process of the present invention may alternatively be carried out by first depositing the difficult-to-etch metal on the substrate followed by depositing and patterning the layer of the sacrificial metal composition. However, this alternative is not as preferable as the sequence illustrated in the figures since the beneficial "lift off" effect discussed above would not be available for aiding in removing the etchable plural metal composition sacrificial metal composition and virtually complete conversion of the difficult-to-etch metal underlying the pattern of sacrificial metal composition to etchable plural metal composition in order to obtain complete removal of the difficult-to-etch metal from the underlying surface where desired.

Once the desired pattern of the difficult to etch metal is obtained according to the method of the invention, the resulting structure may be subjected to further processing if desired. For example, as shown in Figure 3, , the underlying barrier layer 6 may then be patterned using known techniques such as a low power Cl₂-based dry etch using the patterned difficult-to-etch metal (electrode) 8 as the etch mask. Further, where a ferroelectric capacitor is to be formed, node dielectric 10 and upper electrodes 11 may be deposited and patterned using known techniques as shown in Fig. 4.

For ferroelectric capacitors, examples of node dielectric materials are lead zirconate titanate, barium titanate, phase III potassium nitrate, and strontium bismuth tantalate. Barium strontium titanate ((Ba,Sr)TiO₃) is a preferred node dielectric material. The upper electrode material is preferably platinum or iridium.

## Claims

1. A method for forming a patterned difficult-to-etch metal layer, said method comprising:
providing a patterned layer of a sacrificial metal composition on a surface wherein said sacrificial metal composition is capable of reacting with a difficult- to-etch metal, said difficult-to-etch metal being characterized by an inability to easily form volatile halogen compounds, to provide an etchable plural metal composition and wherein said sacrificial metal composition layer is located at regions over said surface where said difficult-to-etch metal is to be subsequently removed, said surface further comprising exposed regions not covered by said sacrificial metal composition layer, said exposed regions being in a pattern corresponding to said patterned difficult-to-etch metal layer to be formed;
depositing a layer of said difficult-to-etch metal on said sacrificial metal composition layer and said exposed regions,
forming an etchable plural metal composition of said difficult-to-etch metal and said sacrificial metal composition where said difficult-to-etch metal overlies said sacrificial metal composition; and
selectively removing said etchable plural metal composition whereby said patterned difficult-to-etch metal layer remains on said surface.

2. A method as claimed in claim 1 wherein said sacrificial metal composition is deposited as a conformal layer on said surface and is patterned prior to depositing said difficult-to-etch metal.

3. A method as claimed in claim 1 or claim 2 wherein said sacrificial metal composition is patterned by forming an overlying patterned mask layer followed by reactive ion etching.

4. A method as claimed in any preceding claim wherein said difficult-to-etch metal is deposited by a directional deposition technique.

5. A method as claimed in any preceding claim wherein said etchable plural metal composition is formed by annealing.

6. A method as claimed in any preceding claim wherein said difficult-to-etch metal is selected from the group consisting of noble metals.

7. A method as claimed in any preceding claim wherein said sacrificial metal composition contains a metal selected from the group consisting of aluminium, titanium, germanium, tin and mixtures thereof.

8. A method as claimed in any preceding claim wherein said removing of said etchable plural metal composition comprises etching or polishing.

9. A method as claimed in any preceding claim wherein said patterned difficult-to-etch metal layer is a platinum or iridium electrode and said surface is on a semiconductor structure containing word lines, bit lines, bit contacts, interlevel dielectric, capacitor contact and a diffusion barrier layer located between said capacitor contact and said electrode.

10. A method as claimed in claim 9 further comprising depositing and patterning node dielectric above said platinum or iridium electrode and forming upper electrodes above said node dielectric.
